# EUROPEAN PATENT SPECIFICATION

(11) **EP 2 849 371 B1**
(45) Date of publication and mention of the grant of the patent: **13.04.2016**
(21) Application number: 13786937.6
(22) Date of filing: 10.05.2013
(51) Int. Cl.: H04J 14/02, H04Q 11/00

(54) **WAVELENGTH LABEL CONFLICT DETECTION METHOD AND DEVICE AND WAVELENGTH LABEL RECEIVING DEVICE**
VERFAHREN UND VORRICHTUNG ZUR ERKENNUNG VON WELLENLÄNGEN-LABEL-KONFLIKTEN UND WELLENLÄNGEN-LABEL-EMPFANGSVORRICHTUNG
PROCÉDÉ ET DISPOSITIF DE DÉTECTION DE CONFLIT D'INDICATEUR DE LONGUEUR D'ONDE ET DISPOSITIF DE RÉCEPTION D'INDICATEUR DE LONGUEUR D'ONDE

(30) Priority: 11.05.2012 CN 201210146376
(43) Date of publication of application: 18.03.2015
(73) Proprietor: ZTE Corporation, Shenzhen, Guangdong 518057 (CN)
(72) Inventor: SHANG, Yingchun, Shenzhen Guangdong 518057 (CN)
(74) Representative: Bergmeier, Werner
(86) International application number: PCT/CN2013/075457
(87) International publication number: WO 2013/166987

(56) References cited:
- CN-A- 101 944 150
- CN-A- 102 195 739
- CN-A- 102 710 323
- US-A1- 2003 067 651
- US-A1- 2008 080 862
- US-A1- 2009 263 125
- US-A1- 2010 150 568

## Description

### TECHNICAL FIELD

The present invention relates to the field of optical communication technologies, and more particularly, to a wavelength label conflict detection method and device and a wavelength label receiving device.

### BACKGROUND OF THE INVENTION

With the development of wavelength division multiplex (WDM) technology, optical signals with tens to hundreds of wavelengths can be simultaneously transmitted in the same fiber in the current optical communication networks. Moreover, technology based on ROADM (Reconfigurable Optical Add-Drop Multiplexer) facilitates the configuration of each wavelength as needed in optical communication, making each wavelength in the optical network not sustain the same path between two sites, or a certain wavelength is not assigned to two certain sites forever.

The wavelength label technology can refer to Appendix D in "Technical Requirements for Reconfigurable Optical Add Drop Multiplexing (ROADM) Equipment" of China Posts and Telecommunications Industry Standard YD/T 2003-2009, which described the wavelength trail monitoring (wavelength label) technology in the ROADM applications. At the source endpoint of the wavelength path, an encoder is used to modulate and encode before the wavelength signals enter into the WDM network, and a unique identifier (wavelength label) in the whole network is added to each wavelength signal; on the respective reference point of each node which the wavelength path passes through, an embedded wavelength label detector can be used to monitor and identify the label of each wavelength passing through this point.

The pilot tone technology involved in the wavelength label is introduced as follows: a pilot tone signal is loaded to each wavelength in the WDM system to achieve a variety of special applications, which has long been studied in the industry. The pilot tone signal sometimes is also called low-frequency dither signal, and the effects of the wavelength signal loaded with the pilot tone signal on transmission performance is almost negligible. For example, in 1993, a plurality of units such as BT Labs in UK and Ericsson in Sweden jointly published "A Transport Network Layer Based On Optical Network Elements" in the Journal of Lightwave Technology, which proposed to use the pilot tone signal to achieve the wavelength channel acknowledgement and power management required by fault management in the WDM system; moreover. In 1994, a patent document titled "Method and apparatus for Monitoring Performance of Optical Transmission Systems" whose Publication No. is US 005513029 by Kim B. Roberts in the Canadian company Nortel proposed a method for monitoring the performance of an optical amplifier, that is, monitoring the pilot tone signal with a known modulation depth, to achieve the estimation of signal and noise components of the optical amplifier. Furthermore, the paper "Signal Tracking and Performance Monitoring in Multi-wavelength Optical Networks" whose paper serial number is WeB2.2 and published in the ECOC'96 conference by Fred Heismann et al from the Bell labs in 1996 disclosed a scheme for achieving online wavelength routing tracking in the WDM network, that is, each wavelength modulates one unique pilot tone signal, and the frequency shift keying mode is used to encode the digital information, the pilot tone signal is monitored at any sites in the optical network so that the wavelength routing information of the entire network can be informed.

The receiving device can detect the wavelength label information transmitted by the source end according to the changes of amplitude and phase of each wavelength label frequency within the time windows, but no method for detecting the wavelength conflict is given in the related art.

US2008/0080862 discloses a method and device to identify optical channels using FFT analysis. US2009/0263125 discloses a method and device to identify wavelength conflicts using pilot tones and FFT analysis.

### SUMMARY OF THE INVENTION

The embodiment of the present invention provides a wavelength label conflict detection method and device and a wavelength label receiving device, to provide a solution for detecting the wavelength label signal conflict, so as to detect the wavelength conflict.

The wavelength label conflict detection method provided in an embodiment of the present invention comprises: perform spectrum analysis on received wavelength label signals, and determine that the wavelength labels conflict when judging that at least one of the following two conditions is met:
there are N successive time windows in M time windows whose corresponding wavelength label signals are wavelength label signals transmitted by loading a wavelength label frequency, the maximum difference value between amplitude values of the N wavelength label signals corresponding to the N time windows is smaller than a preset amplitude threshold value, none of the amplitude values thereof belongs to a normal reference amplitude value range, and both M and N are integers greater than 1;
there are N successive time windows in M time windows whose corresponding wavelength label signals are wavelength label signals transmitted by loading a wavelength label frequency, the maximum difference value between the amplitude values of the N wavelength label signals corresponding to the N time windows is smaller than a preset amplitude threshold value, the maximum difference value of the phase values thereof is smaller than a preset phase threshold value, none of the phase values thereof belongs to a normal reference phase value range, and both M and N are integers greater than 1.

Preferably, the abovementioned method may further have the following feature:
the normal reference amplitude range refers to an amplitude value range determined by the wavelength label receiving device according to the amplitude values of the received wavelength label signals after a single wavelength label source end loads the same wavelength label frequency to transmit the wavelength label signals;
the normal reference phase range refers to a phase range determined by the wavelength label receiving device according to the phase values of the received wavelength label signals after the single wavelength label source end uses the same wavelength label frequency to transmit the wavelength label signals.

Preferably, the abovementioned method may further have the following feature:
the wavelength label receiving device determines an average amplitude value according to a plurality of amplitude values of the received wavelength label signals transmitted by loading the wavelength label frequency, and take a range which takes the average amplitude value as the center and a preset ratio of the average amplitude value as the covering path length as the normal reference amplitude range;
the wavelength label receiving device determines an average phase value according to a plurality of phase values of the received wavelength label signals transmitted by loading the wavelength label frequency, and takes the range which takes the average phase value as the center and a preset error phase value as the covering path length as the normal reference phase range.

Preferably, the abovementioned method may further have the following feature:
the value range of the preset ratio is 5% to 10%, and the value range of the preset error phase is 5° to 10°.
The embodiment of the present invention further provides a wavelength label conflict detection device, and the device comprises a wavelength label conflict detection unit; and the wavelength label conflict detection unit comprises a spectrum analysis module and a conflict detection module;
the spectrum analysis module is configured to perform spectrum analysis on the received wavelength label signals;
the conflict detection module is configured to determine that the wavelength labels conflict when judging that at least one of the following two conditions is met according to the analysis result of the spectrum analysis module:
   there are N successive time windows in the M time windows whose corresponding wavelength label signals are wavelength label signals transmitted by loading the wavelength label frequency, the maximum difference between the amplitude values of the N wavelength label signals corresponding to the N time windows is smaller than the preset amplitude threshold value, none of the amplitude values thereof belongs to the normal reference amplitude value range, and both M and N are integers greater than 1;
   there are N successive time windows in the M time windows whose corresponding wavelength label signals are wavelength label signals transmitted by loading the wavelength label frequency, the maximum difference value between the amplitude values of the N wavelength label signals corresponding to the N time windows is smaller than the preset amplitude threshold value, the maximum difference between the phase values thereof is smaller than the preset phase threshold value, none of the phase values thereof belongs to the normal reference phase value range, and both M and N are integers greater than 1.

Preferably, the abovementioned device may further have the following feature:
the device further comprises a range determination module;
the range determination module is configured to, after receiving the wavelength label signals transmitted by a single wavelength label source end using the same wavelength label frequency, determine a reference amplitude value range according to the amplitude values of the received wavelength label signals; and after receiving the wavelength label signals transmitted by the single wavelength label source end using the same wavelength label frequency, determine a reference phase range according to the phase values of the received wavelength label signals.

Preferably, the abovementioned device may further have the following feature:
the range determination module is configured to, determine an average amplitude value according to the multiple amplitude values of the received wavelength label signals transmitted by loading the wavelength label frequency, and take the range which takes the average amplitude value as the center and the preset ratio of the average amplitude value as the covering path length as the reference amplitude value range; as well as determine an average phase value according to a plurality of phase values of the received wavelength label signals transmitted by loading the wavelength label frequency, and take the range which takes the average phase value as the center and the preset error phase value as the covering path length as the reference phase range.

Preferably, the abovementioned device may further have the following feature:
the value range of the preset ratio is 5% to 10%, and the preset error phase value is 5° to 10°.

The embodiment of the present invention further provides a wavelength label receiving device, and the wavelength label receiving device comprises a splitter, a photoelectric conversion unit, a signal conditioning unit, an analog-to-digital converter, and a wavelength label conflict detection unit which are connected sequentially;
the wavelength label conflict detection unit comprises a spectrum analysis module and a conflict detection module;
the spectrum analysis module is configured to perform spectrum analysis on the received wavelength label signals;
the conflict detection module is configured to, determine that the wavelength labels conflict when judging that at least one of the following two conditions is met according to the analysis result of the spectrum analysis module:
there are N successive time windows in the M time windows whose corresponding wavelength label signals are wavelength label signals transmitted by loading the wavelength label frequency, the maximum difference value between the amplitude values of the N wavelength label signals corresponding to the N time windows is smaller than the preset amplitude threshold value and none of the amplitude values thereof belongs to the normal reference amplitude value range, and both M and N are integers greater than 1;
there are N successive time windows in the M time windows whose corresponding wavelength label signals are wavelength label signals transmitted by loading the wavelength label frequency, the maximum difference value between the amplitude values of the N wavelength label signals corresponding to the N time windows is smaller than the preset amplitude threshold value, the maximum difference value between the phase values thereof is smaller than the preset phase threshold value, none of the phase values thereof belongs to the normal reference phase range, and both M and N are integers greater than 1.

Preferably, the abovementioned wavelength label receiving device may further have the following feature:
the wavelength label conflict detection unit further comprises a reference amplitude range determination module;
the reference amplitude range determination module is configured to, after receiving the wavelength label signals transmitted by the single wavelength label source end using the same wavelength label frequency, determine a reference amplitude value range according to the amplitude values of the received wavelength label signals; preferably, determine an average amplitude value according to a plurality of amplitudes of the received wavelength label signals transmitted by loading the wavelength label frequency, and take the range which takes the average amplitude value as the center and the preset ratio of the average amplitude value as the covering path length as the normal reference amplitude range;

The reference amplitude range determination module is further configured to, after receiving the wavelength label signals transmitted by the single wavelength label source end using the same wavelength label frequency, determine a reference phase range according to the phase values of the received wavelength label signals; preferably, determine an average phase value according to a plurality of phase values of the received wavelength label signals transmitted by loading the wavelength label frequency, and take the range which takes the average phase value as the center and the preset error phase value as the covering path length as the normal reference phase range.

The embodiments of the present invention can judge whether there is a wavelength label conflict or not by analyzing the amplitudes and phases in the wavelength label spectrum, so as to improve the performance of the label receiving device.

### BRIEF DESCRIPTION OF THE DRAWINGS

- **FIG. 1**: is a structural diagram of a wavelength label receiving device;
- **FIG. 2**: is a structural diagram of a wavelength conflict detection unit;
- **FIG.3**: is a schematic diagram of a wavelength label conflict detection method;
- **FIG. 4**: is a schematic diagram of the amplitude and phase value ranges of wavelength label signals transmitted by the single wavelength label source end loading the wavelength label frequency;
- **FIG. 5**: is an illustration of spectral parameters of wavelength label signals within time windows in a first specific embodiment;
- **FIG. 6**: is an illustration of spectral parameters of wavelength label signals within time windows in a second specific embodiment;
- **FIG. 7**: is an illustration of spectral parameters of the wavelength label signals within time windows in a third specific embodiment;
- **FIG. 8**: is an illustration of spectral parameters of the wavelength label signals within time windows in a fourth specific embodiment;
- **FIG. 9**: is an illustration of spectral parameters of the wavelength label signals within time windows in a fifth specific embodiment.

### PREFERRED EMBODIMENTS OF THE INVENTION

The wavelength label information may be represented by various parameters such as amplitude, frequency, phase, and so on of the low-frequency signals carried in the wavelength, and the wavelength label source end can encode and convert the wavelength label information into a binary expression form such as "1" and "0". One or more time windows (the length of the time window is determined by the sampling frequency and the number of sampling points of the spectrum analysis) in which the label source end loads the wavelength label frequency are generally encoded as "1" in the binary of the wavelength label information, and one or more time windows in which the wavelength label frequency is not loaded by the label source end are generally encoded as "0" in the binary of the wavelength label information. The receiving end performs spectrum analysis by taking time window as the unit according to the sampled wavelength label signals to obtain parameters such as amplitude and phase of the wavelength label signals, and then distinguish the binary signals at each wavelength label frequency based on the amplitude and/or phase information at the wavelength label frequency of one or more time windows. A time window for transmitting "1" refers to that the signals within this time window are wavelength label signals transmitted by loading the wavelength label frequency, and a time window for transmitting "0" refers to that the signals within this time window are wavelength label signals transmitted without loading the wavelength label frequency. After receiving the "1" signals in one or more successive time windows, the receiving end determines receiving "1" bit or "1" baud signals sent by the label source end. The receiving end learns the wavelength label information according to the parameters such as amplitude and/or phase of the wavelength label signals within the respective successive time windows.

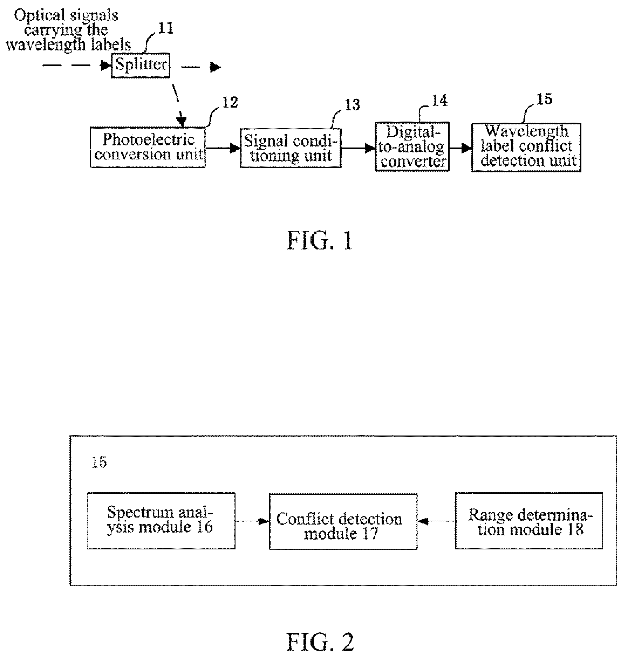

As shown in FIG. 1, the wavelength label receiving device comprises splitter 11, photoelectric conversion unit 12, signal conditioning unit 13, analog-to-digital converter 14, and wavelength label conflict detection unit 15 which are sequentially connected.

The splitter 11 splits part (for example, the splitting ratio is 1% to 5%) of the optical signal carrying the wavelength labels to the photoelectric conversion unit 12.

The photoelectric conversion unit 12 converts the received optical signals into electrical signals.

The signal conditioning unit 13 performs treatments, including functions such as filtering and amplifying as well as the function of converting current signals into voltage signals, on the electrical signals.

The analog-to-digital converter 14 completes the analog-to-digital conversion of the electrical signals, and sends the converted digital signals to the wavelength label conflict detection unit 15.

The wavelength label conflict detection unit 15 uses the digital signals to perform CZT conversion, so as to complete the spectrum analysis of the wavelength label signals, obtain the real part data and imaginary part data of the wavelength labels within the respective time windows, then obtain the amplitude and phase values thereof, and analyze whether a wavelength label conflict occurs or not.

As shown in FIG. 2, the wavelength label conflict detection unit 15 comprises spectrum analysis module 16 and conflict detection module 17.

The spectrum analysis module is configured to perform spectrum analysis on the received wavelength label signals;
the conflict detection module is configured to determine that the wavelength labels conflict when judging at least one of the following two conditions is met according to the analysis result of the spectrum analysis module:
First, there are N successive time windows in the M time windows whose corresponding wavelength label signals are wavelength label signals transmitted by loading the wavelength label frequency, the maximum difference value of the amplitude values of the N wavelength label signals corresponding to the N time windows is smaller than a preset amplitude threshold value and none of the amplitude values thereof belongs to in the reference amplitude value range, and both M and N are integers greater than 1;
Second, there are N successive time windows in the M time windows whose corresponding wavelength label signals are wavelength label signals transmitted by loading the wavelength label frequency, the maximum difference value of the amplitude values of the N wavelength label signals corresponding to the N time windows is smaller than the preset amplitude threshold value, the maximum difference value of the phase values thereof is less than the preset phase threshold value, none of the phase values thereof belongs to the reference phase range, and both M and N are integers greater than 1.

The reference amplitude value and phase ranges may be ranges defaulted in the wavelength label receiving device.

The wavelength label conflict detection unit 15 may further comprise a range determination module, and the reference amplitude value and phase ranges may also be ranges calculated out by the range determination module 18 according to the received signals after the wavelength label source end loads the same wavelength label frequency to transmit the wavelength label signals.

The range determination module 18 is configured to, after receiving the wavelength label signals transmitted by the single wavelength label source end using the same wavelength label frequency, determine the amplitude value range according to the amplitude values of the received wavelength label signals. Preferably, an average amplitude value is determined according to the multiple amplitude values of the received wavelength label signals transmitted by loading the wavelength label frequency, and the range which takes the average amplitude value as the center and the preset ratio of the average amplitude value as the covering path length is taken as the reference amplitude value range.

The range determination module 18 is further configured to, after receiving the wavelength label signals transmitted by the single wavelength label source end using the same wavelength label frequency, determine the phase range according to the phase values of the received wavelength label signals; preferably, determine an average phase value according to a plurality of phase values of the received wavelength label signals transmitted by loading the wavelength label frequency, and take the range which takes the average phase value as the center and the preset error phase value as the covering path length as the reference phase range.

The value range of the preset ratio is 5% to 10%, and the preset error phase value is 5° to 10°.

In addition to the abovementioned wavelength label receiving device, the present scheme can further provide a wavelength label conflict detection device including the abovementioned wavelength label conflict detection unit 15, and the structure and function of the wavelength label conflict detection unit are the same as abovementioned and not repeated here.

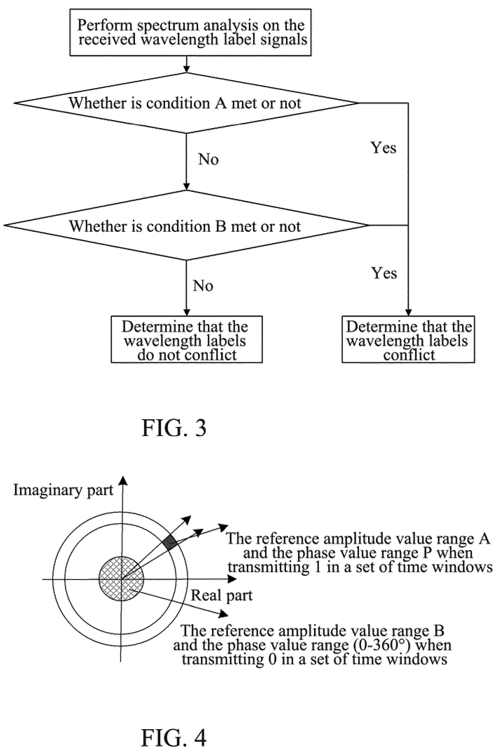

As shown in FIG. 3, the wavelength label conflict detection method comprises: performing spectrum analysis on the received wavelength label signals, and determining that the wavelength labels conflict when judging at least one of the following two conditions is met:
condition A, there are N successive time windows in the M time windows whose corresponding wavelength label signals are wavelength label signals transmitted by loading the wavelength label frequency, the maximum difference value of the amplitude values of the N wavelength label signals corresponding to the N time windows is smaller than the preset amplitude threshold value and none of the amplitude values thereof belongs to the reference amplitude range, and both M and N are integers greater than 1;
condition B, there are N successive time windows in the M time windows whose corresponding wavelength label signals are wavelength label signals transmitted by loading the wavelength label frequency, the maximum difference value of the amplitude values of the N wavelength label signals corresponding to the N time windows is smaller than the preset amplitude threshold value, the maximum difference value of the phase values thereof is smaller than the preset phase threshold value, none of the phase values thereof belongs to the reference phase range, and both M and N are integers greater than 1.

The reference amplitude value range is the amplitude value range determined by the wavelength label receiving device according to the amplitude values of the received wavelength label signals after the single wavelength label source end loads the same wavelength label frequency to transmit the wavelength label signals; preferably, the wavelength label receiving device can determine an average amplitude value according to a plurality of amplitude values of the received wavelength label signals transmitted by loading the wavelength label frequency, and take the range which takes the average amplitude value as the center and the preset ratio (the value range of the preset ratio is 5-10%) of the average amplitude value as the covering path length as the reference amplitude value range.

The reference phase range is the phase range determined by the wavelength label receiving device according to the phase values of the received wavelength label signals after the single wavelength label source end uses the same wavelength label frequency to transmit the wavelength label signals. The wavelength label receiving device determines an average phase value according to a plurality of phase values of the received wavelength label signals transmitted by loading the wavelength label frequency, and take the range which takes the average phase value X as the center and the preset error phase value Y as the covering path length, that is the range from X-Y to X+Y, as the reference phase range, and the value range of the preset error phase value Y is 5° to 10°.

In the following, the present scheme will be described in detail with specific examples.

FIG. 4 is a schematic diagram of real and imaginary part data after performing spectrum analysis on the wavelength label signals when there is no wavelength label conflict. The reference amplitude value range A and the reference phase value range P of the wavelength label signals transmitted by loading the wavelength label frequency, and the reference amplitude value range B and the reference phase value range (the range of 0° to 360°) of the wavelength label signals transmitted without loading the wavelength label frequency, can be obtained from the real and imaginary part data.

In the specific embodiments of the present scheme, transmitting "1" refers to the signal transmission mode of transmitting the wavelength label signals by loading the wavelength label frequency, and transmitting "0" refers to the signal transmission mode of transmitting the wavelength label signals without loading the wavelength label frequency.

### THE FIRST SPECIFIC EMBODIMENT

Two wavelength label source ends use the same wavelength label frequency to transmit the wavelength label information, in the case that the amplitudes of the two wavelength labels are the same, while the phases thereof are different, superimposing the amplitude and phase value ranges when transmitting "1" in the next set of time windows can lead to that the amplitude and phase are different from the amplitude range A and the phase range P.

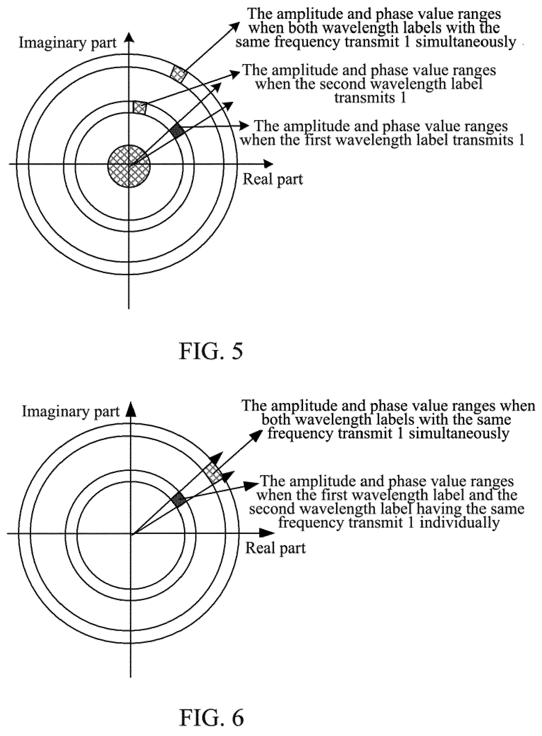

As shown in FIG. 5, the amplitude value ranges of the two wavelength labels are substantially the same, but the phase values thereof have some differences, when both of the wavelength labels transmit 1 in a certain time window, the superimposed result is that the amplitude is increased greatly, and the phase value also has some change. At the demodulating end, when finding that it is 1 being received, there are jumps on both phase and amplitude. Within a set of time windows, if there are two wavelength labels simultaneously transmitting 1, then there is more than one successive time windows in which the amplitude values are in a certain range which is not equal to the amplitude range; if there are two wavelength labels not transmitting 1 simultaneously, there are more than one successive time windows in which the amplitude values are in a certain range and in the amplitude range A, but the phase values thereof are within a certain range but do not belong to the phase range P; at this point, a wavelength label conflict can be determined and an alarm is sent.

### THE SECOND SPECIFIC EMBODIMENT

Two wavelength label source ends use the same wavelength label frequency to transmit the wavelength label information, in the case that the amplitudes and phases of the two wavelength labels are the same, superimposing the amplitude and phase value ranges when transmitting 1 in the next set of time windows can lead to that the amplitude and phase are different from the amplitude range A and the phase range P.

As shown in FIG. 6, the amplitude and phase ranges of the two wavelength labels are the same, when both of the wavelength labels transmit 1 in a particular time window, the superimposed result is that the amplitude value is increased greatly (doubled), while the phase value does not change. Therefore, when the demodulating end receives 1, there is no change in the phase, but there are jumps in the amplitude. Within a certain set of time windows, there are more than one successive time windows in which the amplitude values are in a certain range but do not belong to the amplitude range A. At this point, a wavelength label conflict can be determined and an alarm is sent.

### THE THIRD SPECIFIC EMBODIMENT

Two wavelength label source ends use the same wavelength label frequency to transmit the wavelength label information, in the case that the amplitudes and phases of the two wavelength labels are different, superimposing the amplitude and phase value ranges when transmitting 1 in the next set of time windows can lead to that the amplitude and phase are different from the amplitude range A and the phase range P.

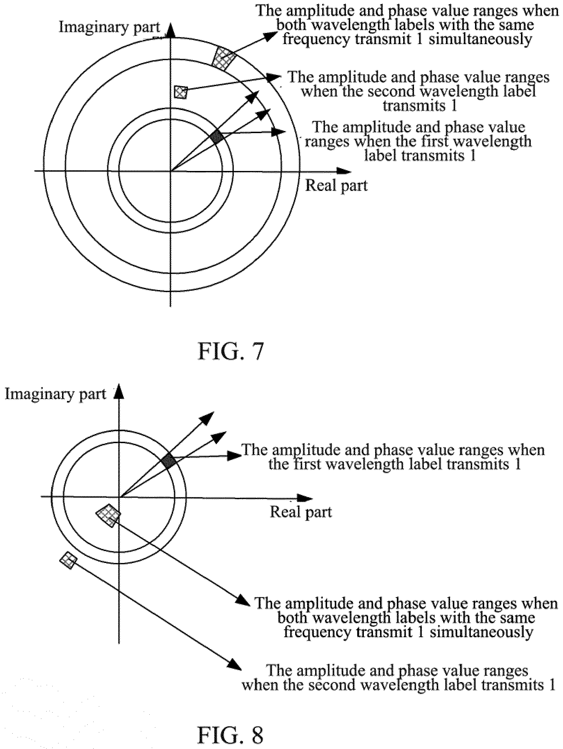

As shown in FIG. 7, the amplitude and phase value ranges of the two wavelength labels are different. When both of the wavelength labels transmit 1 within a certain time window, the superimposed result may be that the amplitude is increased greatly and the phase value also has some change. Therefore, at the demodulating end, when finding that it is 1 being received, there are jumps on both the phase and the amplitude. Within a set of time windows, if there are two wavelength labels transmitting 1 simultaneously, there is more than one successive time windows in which the amplitude values are in a certain range which is not equal to the amplitude range A; when 1 is not transmitted simultaneously, the amplitude and phase when the other wavelength label with the same frequency transmits 1 are different from the amplitude and phase when the original wavelength transmits 1, that is, there are more than one successive time windows in which amplitude values are in a certain range but do not belong to the amplitude range A. At this point, a wavelength label conflict can be determined and an alarm is sent.

### THE FOURTH SPECIFIC EMBODIMENT

Two wavelength label source ends use the same wavelength label frequency to transmit the wavelength label information, in the case that the amplitudes and phases of the two wavelength labels are different, and the phases thereof are different by 180°, superimposing the amplitude and phase value ranges when transmitting 1 in the next set of time windows can lead to that the amplitude and phase are different from the amplitude range A and the phase range P.

As shown in FIG. 8, the amplitude value ranges and the phase values of the two wavelength labels are different, and the phase difference is 180°, when both of the wavelength labels transmit 1 within a certain time window, the superimposed result may be that the amplitude is reduced greatly, moreover the amplitude occurs within the amplitude value range when the wavelength label transmits 0. Therefore, at the demodulating end, when finding that it is 1 being received, there are jumps on both the phase and amplitude. Within a set of time windows, there is more than one successive time windows in which the amplitude values are in a certain range but do not belong to the amplitude range A; or within a certain set of time windows, there are more than one successive time windows in which the amplitude values are within a certain range, and the phase values are within a certain range which is not equal to the phase range P. At this point, a wavelength label conflict can be determined and an alarm is sent.

### THE FIFTH SPECIFIC EMBODIMENT

Two wavelength label source ends use the same wavelength label frequency to transmit the wavelength label information, in the case that the amplitudes and phases of the two wavelength labels are different, and the phase difference is 60°, superimposing the amplitude and phase value ranges when transmitting 1 in the next set of time windows can lead to that the amplitude and phase are different from the amplitude range A and the phase range P.

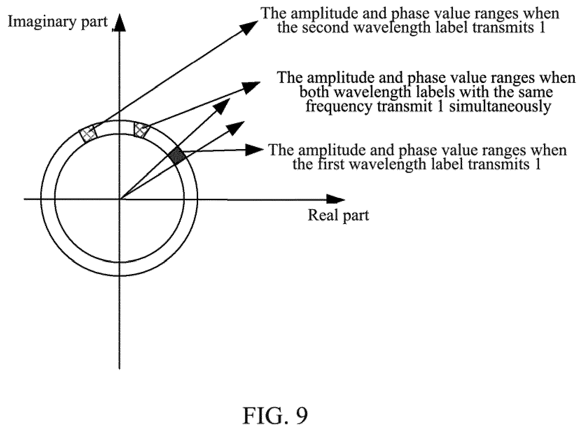

As shown in FIG. 9, the amplitude value ranges of the two wavelength labels are the same, but the phase values thereof are different and the difference is about 60 °. When both of the wavelength labels transmit 1 within a certain time window, the superimposed result is that the amplitude range does not change and equals to the amplitude range A when the original wavelength label transmits 1 individually, but the phase value thereof changes by 30°. Therefore, at the demodulating end, when finding that it is 1 being received, there are jumps on the phase but not on the amplitude. Within a set of time windows, there are more than one successive time windows in which the amplitude values are in a certain range which equals to the amplitude range A, and the phase values thereof are within a certain range which is not equal to the phase range P. At this point, a wavelength label conflict can be determined and an alarm is sent.

It should be noted that, in the case of no conflict, the embodiments and features in the embodiments of the present application may be arbitrarily combined with each other.

Of course, the present invention may have a variety of other embodiments, and without departing from the present invention, a person skilled in the art can make various changes and modifications according to the present invention, and these corresponding change and modifications should belong to the protection scope of the appended claims of the present invention.

Those ordinarily skilled in the art can understand that all or some of steps of the abovementioned method may be completed by the programs instructing the relevant hardware, and the programs may be stored in a computer-readable storage medium, such as read only memory, magnetic or optical disk. Alternatively, all or some of the steps of the abovementioned embodiments may also be implemented by using one or more integrated circuits. Accordingly, each module/unit in the abovementioned embodiments may be realized in a form of hardware, or in a form of software function modules. The present invention is not limited to any specific form of hardware and software combinations.

### INDUSTRIAL APPLICABILITY

The embodiments of the present invention can judge whether a wavelength label conflict occurs or not by analyzing the amplitudes and phases in the wavelength label spectrum, so as to improve the performance of the label receiving device.

## Claims

1. A method of detecting wavelength label conflict, comprising:
performing spectrum analysis on received wavelength label signals;
determining that wavelength labels conflict when judging that at least one of the following two conditions is met:
there are N successive time windows in M time windows whose corresponding wavelength label signals are wavelength label signals transmitted by loading a wavelength label frequency, a maximum difference value between amplitude values of N wavelength label signals corresponding to the N time windows is smaller than a preset amplitude threshold value, none of the amplitude values thereof belongs to a reference amplitude value range, and both M and N are integers greater than 1;
there are N successive time windows in M time windows whose corresponding wavelength label signals are wavelength label signals transmitted by loading the wavelength label frequency, the maximum difference value between the amplitude values of the N wavelength label signals corresponding to the N time windows is smaller than a preset amplitude threshold value, a maximum difference value of phase values thereof is smaller than a preset phase threshold value, none of the phase values thereof belongs to a reference phase range, and both M and N are integers greater than 1.

2. The method of claim 1, wherein,
the reference amplitude range refers to an amplitude value range determined by the wavelength label receiving device according to amplitude values of received wavelength label signals when a single wavelength label source end loads the same wavelength label frequency to send the wavelength label signals;
the reference phase range refers to a phase range determined by the wavelength label receiving device according to phase values of the received wavelength label signals when the single wavelength label source end uses the same wavelength label frequency to send the wavelength label signals.

3. The method of claim 2, wherein,
the wavelength label receiving device determines an average amplitude value according to a plurality of amplitude values of the received wavelength label signals transmitted by loading the wavelength label frequency, and takes a range which takes the average amplitude value as a center and a preset ratio of the average amplitude value as a covering path length as the reference amplitude range;
the wavelength label receiving device determines an average phase value according to a plurality of phase values of the received wavelength label signals transmitted by loading the wavelength label frequency, and takes a range which takes the average phase value as a center and a preset error phase value as a covering path length as the reference phase range.

4. The method of claim 3, wherein,
a value range of the preset ratio is 5-10%, and a value range of the preset error phase is 5° to 10°.

5. A wavelength label conflict detection device, wherein, the device comprises a wavelength label conflict detection unit;
the wavelength label conflict detection unit comprises a spectrum analysis module and a conflict detection module;
the spectrum analysis module is configured to perform spectrum analysis on received wavelength label signals;
the conflict detection module is configured to determine that wavelength labels conflict when judging that at least one of the following two conditions is met according to an analysis result of the spectrum analysis module:
there are N successive time windows in M time windows whose corresponding wavelength label signals are wavelength label signals transmitted by loading a wavelength label frequency, a maximum difference between amplitude values of N wavelength label signals corresponding to the N time windows is smaller than a preset amplitude threshold value, and none of the amplitude values thereof belongs to a reference amplitude value range, and both M and N are integers greater than 1;
there are N successive time windows in M time windows whose corresponding wavelength label signals are wavelength label signals transmitted by loading the wavelength label frequency, the maximum difference between the amplitude values of the N wavelength label signals corresponding to the N time windows is smaller than the preset amplitude threshold value, a maximum difference between phase values thereof is smaller than a preset phase threshold value, none of the phase values thereof belongs to a reference phase value range, and both M and N are integers greater than 1.

6. The device of claim 5, wherein, the device further comprises a range determination module;
the range determination module is configured to, after receiving the wavelength label signals transmitted by a single wavelength label source end using a wavelength label frequency, determine the reference amplitude value range according to amplitude values of the received wavelength label signals; and after receiving the wavelength label signals transmitted by the single wavelength label source end using the same wavelength label frequency, determine the reference phase range according to phase values of the received wavelength label signals.

7. The device of claim 6, wherein,
the range determination module is configured to, determine an average amplitude value according to a plurality of amplitude values of the received wavelength label signals transmitted by loading the wavelength label frequency, and take a range which takes the average amplitude value as a center and a preset ratio of the average amplitude value as a covering path length as the reference amplitude value range; as well as determine an average phase value according to a plurality of phase values of the received wavelength label signals transmitted by loading the wavelength label frequency, and take a range which takes the average phase value as a center and a preset error phase value as a covering path length as the reference phase range.

8. The device of claim 7, wherein,
a value range of the preset ratio is 5-10%, and the preset error phase value is 5° to 10°.

9. A wavelength label receiving device comprising, connected sequentially, a splitter, a photoelectric conversion unit, a signal conditioning unit, an analog-to-digital converter, and the wavelength label conflict detection unit of any of claims 5-7.

## Patentansprüche

1. Verfahren zum Detektieren eines Wellenlängen-Label-Konflikts, umfassend:
Ausführen einer Spektralanalyse an empfangenen Wellenlängen-Label-Signalen;
Bestimmen, dass Wellenlängen-Label in Konflikt stehen, wenn beurteilt wird, dass wenigstens eine der folgenden zwei Bedingungen erfüllt ist:
in M Zeitfenstern, deren entsprechende Wellenlängen-Label-Signale Wellenlängen-Label-Signale sind, die durch Laden einer Wellenlängen-Label-Frequenz übermittelt werden, gibt es N aufeinanderfolgende Zeitfenster, ein maximaler Differenzwert zwischen den Amplitudenwerten von N Wellenlängen-Label-Signalen, die den N Zeitfenstern entsprechen, ist kleiner als ein im Voraus festgelegter Amplitudenschwellenwert, keiner der Amplitudenwerte davon gehört zu einem Referenzamplitudenwertebereich, und M und N sind beide ganze Zahlen größer als 1;
in M Zeitfenstern, deren entsprechende Wellenlängen-Label-Signale Wellenlängen-Label-Signale sind, die durch Laden der Wellenlängen-Label-Frequenz übermittelt werden, gibt es N aufeinanderfolgende Zeitfenster, der maximale Differenzwert zwischen den Amplitudenwerten der N Wellenlängen-Label-Signale, die den N Zeitfenstern entsprechen, ist kleiner als ein im Voraus festgelegter Amplitudenschwellenwert, ein maximaler Differenzwert der Phasenwerte davon ist kleiner als ein im Voraus festgelegter Phasenschwellenwert, keiner der Phasenwerte davon gehört zu einem Referenzphasenbereich, und M und N sind beide ganze Zahlen größer als 1.

2. Verfahren nach Anspruch 1, wobei
sich der Referenzamplitudenbereich auf einen Amplitudenwertebereich bezieht, der durch die Wellenlängen-Label-Empfangsvorrichtung gemäß Amplitudenwerten empfangener Wellenlängen-Label-Signale bestimmt wird, wenn ein Einzelwellenlängen-Quellen-Ende dieselbe Wellenlängen-Label-Frequenz lädt, um die Wellenlängen-Label-Signale zu senden;
sich der Referenzphasenbereich auf einen Phasenbereich bezieht, der durch die Wellenlängen-Label-Empfangsvorrichtung gemäß Phasenwerten der empfangenen Wellenlängen-Label-Signale bestimmt wird, wenn das Einzelwellenlängen-Label-Quellen-Ende dieselbe Wellenlängen-Label-Frequenz zum Senden der Wellenlängen-Label-Signale verwendet.

3. Verfahren nach Anspruch 2, wobei
die Wellenlängen-Label-Empfangsvorrichtung einen durchschnittlichen Amplitudenwert gemäß einer Vielzahl von Amplitudenwerten der empfangenen Wellenlängen-Label-Signale bestimmt, die durch Laden der Wellenlängen-Label-Frequenz übermittelt werden, und einen Bereich, der den durchschnittlichen Amplitudenwert als eine Mitte und ein im Voraus festgelegtes Verhältnis des durchschnittlichen Amplitudenwerts als eine Abdeckweglänge nimmt, als den Referenzamplitudenbereich nimmt;
die Wellenlängen-Label-Empfangsvorrichtung einen durchschnittlichen Phasenwert gemäß einer Vielzahl von Phasenwerten der empfangenen Wellenlängen-Label-Signale, die durch Laden der Wellenlängen-Label-Frequenz übermittelt werden, bestimmt und einen Bereich, der den durchschnittlichen Phasenwert als eine Mitte und einen im Voraus festgelegten Fehlerphasenwert als eine Abdeckweglänge nimmt, als den Referenzphasenbereich nimmt.

4. Verfahren nach Anspruch 3, wobei
ein Wertebereich des im Voraus festgelegten Verhältnisses 5-10 % ist und ein Wertebereich der im Voraus festgelegten Fehlerphase 5° bis 10° ist.

5. Wellenlängen-Label-Konflikt-Detektionsvorrichtung, wobei die Vorrichtung eine Wellenlängen-Label-Konflikt-Detektionseinheit umfasst; wobei die Wellenlängen-Label-Konflikt-Detektionseinheit ein Spektralanalysemodul und ein Konfliktdetektionsmodul umfasst;
das Spektralanalysemodul ausgestaltet ist, an empfangenen Wellenlängen-Label-Signalen eine Spektralanalyse auszuführen;
das Konfliktdetektionsmodul ausgestaltet ist zu bestimmen, dass Wellenlängen-Label in Konflikt stehen, wenn beurteilt wird, dass gemäß einem Analyseergebnis des Spektralanalysemoduls wenigstens eine der folgenden zwei Bedingungen erfüllt ist:
in M Zeitfenstern, deren entsprechende Wellenlängen-Label-Signale Wellenlängen-Label-Signale sind, die durch Laden einer Wellenlängen-Label-Frequenz übermittelt werden, gibt es N aufeinanderfolgende Zeitfenster, eine maximale Differenz zwischen den Amplitudenwerten von N Wellenlängen-Label-Signalen, die den N Zeitfenstern entsprechen, ist kleiner als ein im Voraus festgelegter Amplitudenschwellenwert, und keiner der Amplitudenwerte davon gehört zu einem Referenzamplitudenwertebereich, und M und N sind beide ganze Zahlen größer als 1;
in M Zeitfenstern, deren entsprechende Wellenlängen-Label-Signale Wellenlängen-Label-Signale sind, die durch Laden der Wellenlängen-Label-Frequenz übermittelt werden, gibt es N aufeinanderfolgende Zeitfenster, die maximale Differenz zwischen den Amplitudenwerten der N Wellenlängen-Label-Signale, die den N Zeitfenstern entsprechen, ist kleiner als der im Voraus festgelegte Amplitudenschwellenwert, eine maximale Differenz zwischen den Phasenwerten davon ist kleiner als ein im Voraus festgelegter Phasenschwellenwert, keiner der Phasenwerte davon gehört zu einem Referenzphasenwertebereich, und M und N sind beide ganze Zahlen größer als 1.

6. Vorrichtung nach Anspruch 5, wobei die Vorrichtung ferner ein Bereichsbestimmungsmodul umfasst;
wobei das Bereichsbestimmungsmodul ausgestaltet ist, nach dem Empfang der Wellenlängen-Label-Signale, die durch ein Einzelwellenlängen-Label-Quellen-Ende unter Verwendung einer Wellenlängen-Label-Frequenz übermittelt worden sind, den Referenzamplitudenwertebereich gemäß Amplitudenwerten der empfangenen Wellenlängen-Label-Signale zu bestimmen; und nach dem Empfang der Wellenlängen-Label-Signale, die durch das Einzelwellenlängen-Label-Quellen-Ende unter Verwendung derselben Wellenlängen-Label-Frequenz übermittelt worden sind, den Referenzphasenbereich gemäß Phasenwerten der empfangenen Wellenlängen-Label-Signale zu bestimmen.

7. Vorrichtung nach Anspruch 6, wobei
das Bereichsbestimmungsmodul ausgestaltet ist, einen durchschnittlichen Amplitudenwert gemäß einer Vielzahl von Amplitudenwerten der empfangenen Wellenlängen-Label-Signale, die durch Laden der Wellenlängen-Label-Frequenz übermittelt werden, zu bestimmen, und einen Bereich, der den durchschnittlichen Amplitudenwert als eine Mitte und ein im Voraus festgelegtes Verhältnis des durchschnittlichen Amplitudenwerts als eine Abdeckweglänge nimmt, als den Referenzamplitudenwertebereich zu nehmen; sowie einen durchschnittlichen Phasenwert gemäß einer Vielzahl von Phasenwerten der empfangenen Wellenlängen-Label-Signale, die durch Laden der Wellenlängen-Label-Frequenz übermittelt werden, zu bestimmen und einen Bereich, der den durchschnittlichen Phasenwert als eine Mitte und einen im Voraus festgelegten Fehlerphasenwert als eine Abdeckweglänge nimmt, als den Referenzphasenbereich zu nehmen.

8. Vorrichtung nach Anspruch 7, wobei
ein Wertebereich des im Voraus festgelegten Verhältnisses 5-10 % ist und der im Voraus festgelegte Fehlerphasenwert 5° bis 10° ist.

9. Wellenlängen-Label-Empfangsvorrichtung, die aufeinanderfolgend verbunden einen Splitter, eine photoelektrische Umsetzungseinheit, eine Signalaufbereitungseinheit, einen Analog/Digital-Umsetzer und die Wellenlängen-Label-Konflikt-Detektionseinheit nach einem der Ansprüche 5-7 umfasst.

## Revendications

1. Méthode pour détecter un conflit d'indicateur de longueur d'onde, comprenant les étapes suivantes :
exécuter une analyse spectrale de signaux d'indicateur de longueur d'onde reçus ;
déterminer ce conflit d'indicateur de longueur d'onde en jugeant que l'une au moins des conditions suivantes est satisfaite ;
il existe N fenêtres temporelles successives dans M fenêtres temporelles, dont les signaux d'indicateur de longueur d'onde correspondants sont des signaux d'indicateur de longueur d'onde transmis par chargement d'une fréquence d'indicateur de longueur d'onde, une valeur de différence maximale entre des valeurs d'amplitude de N signaux d'indicateur de longueur d'onde correspondant aux N fenêtres temporelles est inférieure à une valeur de seuil d'amplitude préréglée, aucune de ces valeurs d'amplitude n'appartient à une gamme de valeurs d'amplitude de référence, et aussi bien M que N sont des nombres entiers supérieurs à 1 :
il existe N fenêtres temporelles successives dans M fenêtres temporelles, dont les signaux d'indicateur de longueur d'onde correspondants sont des signaux d'indicateur de longueur d'onde transmis par chargement de la fréquence d'indicateur de longueur d'onde, la valeur de différence maximale entre les valeurs d'amplitude des N signaux d'indicateur de longueur d'onde correspondant aux N fenêtres temporelles est inférieure à une valeur de seuil d'amplitude préréglée, une valeur de différence maximale des valeurs de phase de ces signaux est inférieure à une valeur de seuil de phase, aucune des valeurs de seuil de ces signaux n'appartient à une gamme de phases de référence, et aussi bien M que N sont des nombres entiers supérieurs à 1.

2. Méthode selon la revendication 1, dans laquelle la gamme d'amplitude de référence est une gamme de valeurs d'amplitude déterminée par le dispositif recevant l'indicateur de longueur d'onde selon des valeurs d'amplitude de signaux d'indicateur de longueur d'onde reçus lorsque qu'une terminaison source d'indicateur de longueur d'onde individuelle charge la même fréquence d'indicateur de longueur d'onde pour envoyer les signaux d'indicateur de longueur d'onde ;
la gamme de phases de référence est une gamme de phases déterminée par le dispositif recevant l'indicateur de longueur d'onde selon des valeurs de phase des signaux d'indicateur de longueur d'onde reçus lorsque que la terminaison source d'indicateur de longueur d'onde individuelle utilise la même fréquence d'indicateur de longueur d'onde pour envoyer les signaux d'indicateur de longueur d'onde.

3. Méthode selon la revendication 2, dans laquelle le dispositif recevant l'indicateur de longueur d'onde détermine une valeur d'amplitude moyenne sur la base d'une multitude de valeurs d'amplitude des signaux d'indicateur de longueur d'onde reçus, transmis par chargement de la fréquence d'indicateur de longueur d'onde, et adopte une étendue qui adopte la valeur d'amplitude moyenne en tant qu'un centre et un ratio prédéfini de la valeur d'amplitude moyenne en tant qu'une longueur de trajet de parcours en tant que la gamme d'amplitudes de référence ;
le dispositif recevant l'indicateur de longueur d'onde détermine une valeur de phase moyenne sur la base d'une multitude de valeurs de phase des signaux d'indicateur de longueur d'onde reçus, transmis par chargement de la fréquence d'indicateur de longueur d'onde, et adopte une étendue qui adopte la valeur de phase moyenne en tant qu'un centre et une valeur d'erreur de phase prédéfinie en tant qu'une longueur de trajet de parcours en tant que la gamme de phases de référence.

4. Méthode selon la revendication 3, dans laquelle
une gamme de valeurs du ratio préréglé est de 5-10% et une gamme de valeurs de l'erreur de phase préréglée est de 5° à 10°.

5. Dispositif de détection d'un conflit d'indicateur de longueur d'onde, dans lequel le dispositif comporte une unité de détection d'un conflit d'indicateur de longueur d'onde ;
l'unité de détection d'un conflit d'indicateur de longueur d'onde comporte un module d'analyse spectrale et un module de détection de conflits ;
le module d'analyse spectrale est configuré pour exécuter une analyse spectrale des signaux d'indicateur de longueur d'onde reçus ;
le module de détection de conflits est configuré pour déterminer ce conflit d'indicateur de longueur d'onde en jugeant que l'une au moins des conditions suivantes est satisfaite sur la base d'un résultat d'analyse du module d'analyse spectrale ;
il existe N fenêtres temporelles successives dans M fenêtres temporelles, dont les signaux d'indicateur de longueur d'onde correspondants sont des signaux d'indicateur de longueur d'onde transmis par chargement d'une fréquence d'indicateur de longueur d'onde, une différence maximale entre des valeurs d'amplitude de N signaux d'indicateur de longueur d'onde correspondant aux N fenêtres temporelles est inférieure à une valeur de seuil d'amplitude préréglée, et aucune de ces valeurs d'amplitude n'appartient à une gamme de valeurs d'amplitude de référence, et aussi bien M que N sont des nombres entiers supérieurs à 1 :
il existe N fenêtres temporelles successives dans M fenêtres temporelles, dont les signaux d'indicateur de longueur d'onde correspondants sont des signaux d'indicateur de longueur d'onde transmis par chargement de la fréquence d'indicateur de longueur d'onde, la valeur de différence maximale entre les valeurs d'amplitude des N signaux d'indicateur de longueur d'onde correspondant aux N fenêtres temporelles est inférieure à la valeur de seuil d'amplitude préréglée, une différence maximale entre des valeurs de phase de ces signaux est inférieure à une valeur de seuil de phase, aucune des valeurs de seuil de ces signaux n'appartient à une gamme de phases de référence, et aussi bien M que N sont des nombres entiers supérieurs à 1.

6. Dispositif selon la revendication 5, dans lequel le dispositif comporte en outre un module de détermination de gamme ;
le module de détermination de gamme est configuré pour, après avoir reçu les signaux d'indicateur de longueur d'onde transmis par une terminaison source d'indicateur de longueur d'onde individuelle utilisant une fréquence d'indicateur de longueur d'onde, déterminer la gamme de valeurs d'amplitude de référence sur la base de valeurs d'amplitude des signaux d'indicateur de longueur d'onde reçus ; et après avoir reçu les signaux d'indicateur de longueur d'onde transmis par la terminaison source individuelle utilisant la même fréquence d'indicateur de longueur d'onde, déterminer la gamme de phase de référence sur la base de valeurs de phase des signaux d'indicateur de longueur d'onde reçus.

7. Dispositif selon la revendication 6, dans lequel
le module de détermination de gamme est configuré pour déterminer une valeur d'amplitude moyenne sur la base d'une multitude de valeurs d'amplitude des signaux d'indicateur de longueur d'onde reçus, transmis par chargement de la fréquence d'indicateur de longueur d'onde, et adopter une étendue qui adopte la valeur d'amplitude moyenne en tant qu'un centre et un ratio prédéfini de la valeur d'amplitude moyenne en tant qu'une longueur de trajet de parcours en tant que la gamme de valeurs d'amplitude de référence ; aussi bien que pour déterminer une valeur de phase moyenne sur la base d'une multitude de valeurs de phase des signaux d'indicateur de longueur d'onde transmis par chargement de la fréquence d'indicateur de longueur d'onde, et adopter une gamme qui adopte la valeur de phase moyenne en tant qu'un centre et une valeur d'erreur de phase préréglée en tant qu'une longueur de trajet de parcours en tant que la gamme de phases de référence.

8. Dispositif selon la revendication 7, dans lequel une gamme de valeurs du ratio préréglé est de 5-10%, et la valeur d'erreur de phase préréglée est de 5° à 10°.

9. Dispositif de réception d'indicateur de longueur d'onde, comportant, connectés séquentiellement, un répartiteur, une unité de conversion photoélectrique, une unité d'adaptation de signaux, un convertisseur analogique-numérique, et l'unité de détection de conflits d'indicateur de longueur d'onde selon l'une des revendications 5-7.
